(19) Europäisches Patentamt
European Patent Office
Office européen des brevets

(11) **EP 2 555 019 B1**

(12) **EUROPÄISCHE PATENTSCHRIFT**

(45) Veröffentlichungstag und Bekanntmachung des Hinweises auf die Patenterteilung:
**05.08.2015   Patentblatt 2015/32**

(51) Int Cl.:
*G01V 3/10* *(2006.01)*          *H03K 17/95* *(2006.01)*

(21) Anmeldenummer: **11176644.0**

(22) Anmeldetag: **05.08.2011**

(54) **Induktiver Näherungssensor**

Inductive proximity sensor

Détecteur d'approximation inductif

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**06.02.2013   Patentblatt 2013/06**

(73) Patentinhaber: **SICK AG**
**79183 Waldkirch (DE)**

(72) Erfinder:
• **Thoss, Sascha**
**79106 Freiburg (DE)**
• **Lissner, André**
**79104 Freiburg (DE)**

(74) Vertreter: **Hehl, Ulrich**
**SICK AG**
**Intellectual Property**
**Erwin-Sick-Strasse 1**
**79183 Waldkirch (DE)**

(56) Entgegenhaltungen:
**EP-A2- 0 371 261          EP-A2- 0 479 078**
**EP-A2- 1 455 454          DE-A1- 10 012 830**
**DE-A1- 10 244 104          DE-A1- 19 911 958**
**DE-A1-102004 029 192     US-A- 5 994 897**

• **DYM ET AL: "Dual Ramp Analog to Digital Converter with Divide Function for Graphic Tablet", IP.COM JOURNAL, IP.COM INC., WEST HENRIETTA, NY, US, 1. August 1982 (1982-08-01), XP013040762, ISSN: 1533-0001**

**Beschreibung**

Die vorliegende Erfindung betrifft einen Näherungssensor, insbesondere einen induktiven Näherungssensor.

Solche induktiven Näherungssensoren dienen der Erkennung eines in einem Beeinflussungsbereich des Näherungssensors eingebrachten, insbesondere metallischen oder elektrisch gut leitenden Körpers, genannt Target. Herkömmliche Näherungssensoren bestehen aus einem Oszillator, der eine Spule umfasst, die bei schwingendem Oszillator ein Magnetfeld erzeugt. In einem in das Magnetfeld eingebrachten, zu detektierenden Target, werden Wirbelströme induziert, die ein dem Magnetfeld entgegen gerichtetes Gegenfeld erzeugen und somit dem Oszillator Energie entziehen. Der Oszillator ist bei den bekannten Näherungssensoren so dimensioniert, dass dieser Energieentzug bei einem bestimmten Targetabstand zum Zusammenbruch der Schwingung des Oszillators oder zu einer bestimmten Amplitude führt. Dieser Vorgang wird dann zum Zweck der Detektion des Targets erfasst.

Derartige Näherungssensoren weisen in der Regel einen für bestimmte Anwendungen zu geringen Schaltabstand auf. Der Schaltabstand bezeichnet den maximalen Abstand eines Targets von dem Näherungssensor, bei dem eine Detektion des Targets durch den Sensor noch zuverlässig möglich ist.

Da sich ferromagnetische und nicht ferromagnetische Materialien bei der Beeinflussung von bekannten Näherungssensoren stark unterscheiden, führen Targets aus verschiedenen Materialien zu unterschiedlichen Schaltabständen. Dies ist in vielen Anwendungen unerwünscht und nachteilig.

Die Patentanmeldung EP 0 371 261 A2 betrifft ein Verfahren und einen induktiven Näherungssensor mit einer Treiberspule und einer Sensorspule. Gemäß EP 0 371 261 A2 können mittels des Verfahrens dia- und paramagnetische Metalle untereinander und auch von ferromagnetischen Metallen unterschieden werden. DE 10 2004 029 192 A1 offenbart einen induktiven Näherungsschalter, wobei die Sendespule permanent mit einer nahezu konstanten Amplitude betrieben wird.

DE 102 44 104 A1 offenbart einen induktiven Näherungsschalter mit einer Sendespule und zwei Empfangsspulen.

DE 199 11 958 A1 offenbart ein Verfahren für eine induktive Messung des Abstandes zwischen einem Werkstück und einem Arbeitskopf, wobei das Verfahren weitgehend unabhängig von der Materialart des zu bearbeitenden Werkstückes ist. Eine Veröffentlichung DYM ET AL: "Dual Ramp Analog to Digital Converter with Divide Function for Graphic Tablet", betrifft ein kapazitives Grafiktablett.

Der Erfindung liegt die Aufgabe zugrunde, einen induktiven Näherungssensor zu schaffen, der eine erhöhte Empfindlichkeit aufweist, gegenüber dem Stand der Technik erhöhte Schaltabstände ermöglicht, dessen Schaltabstände unabhängig vom Targetmaterial sind und welcher außerdem mit verringerten Kosten hergestellt werden kann.

Die Aufgabe wird gelöst mit induktiven Näherungssensoren gemäß der Ansprüche 1 und 2 und mit Verfahren gemäß der Ansprüche 8 und 9.

Aufgrund dieser Ausbildung des erfindungsgemäßen induktiven Näherungssensors werden besonders weite Abstandsmessungen und hohe Empfindlichkeiten erreicht, wobei die Abstandsmessung weitgehend unabhängig von dem leitfähigen Targetmaterial ist und damit weitgehend materialunabhängig ist. Das Verhältnis der Amplitude der gemessenen Empfangsspannung zur Amplitude der Sendespannung oder die gemessene Empfangsspannung bei konstanter Sendespannung ist ein Maß für den Targetabstand. Durch die Spannungsverhältnisbildung oder die Messung der Empfangsspannung ist eine kontinuierliche Abstandsmessung möglich und nicht nur die Bestimmung eines Schaltpunktes.

Da lediglich ein Spannungsverhältnis aus Empfangsspannung und Sendespannung gebildet wird oder bei konstanter Sendespannung lediglich die Empfangsspannung gemessen wird, ist das Ergebnis unabhängig von einer Referenzgröße. wie beispielsweise bei Widerständen oder Kondensatoren, deren Werte sich aufgrund von Alterung oder Temperatureinflüssen stark ändern können.

Bevor auf die Funktionsweise des erfindungsgemäßen induktiven Näherungssensors eingegangen wird, seien zunächst dessen Komponenten näher erläutert:

Der erfindungsgemäße induktive Näherungssensor weist eine Sendespule auf, die elektrisch mit der Anregungseinrichtung verbunden ist und von dieser angeregt wird.

Die Anregungseinrichtung kann im Rahmen der Erfindung aus einer Einheit bestehen oder auch mehrere elektrisch miteinander verbundene und örtlich getrennte Komponenten aufweisen. Die Anregungseinrichtung kann zudem eine einzige Spannungsquelle zur Anregung der Sendespule aufweisen.

Die Sendespule ist induktiv mit der Empfangsspule gekoppelt. Dadurch induzieren die zeitlich veränderlichen magnetischen Felder, die durch die Anregung der Sendespule erzeugt werden, eine Spannung in der Empfangsspule, die Empfangsspannung.

Weiter ist erfindungsgemäß die Auswerteeinrichtung vorgesehen, die mit der Sendespule und/oder der Anregungseinrichtung einerseits sowie mit der Empfangsspule andererseits elektrisch verbunden ist und eine Sendespannung der Sendespule und/oder der Anregungseinrichtung sowie eine Empfangsspannung der Empfangsspule empfängt und auswertet, derart dass ein Spannungsverhältnis zwischen Sendespannung und Empfangsspannung erzeugt und ausgewertet wird. Diese Signalauswertung erzeugt dann ein Ausgabesignal, das abhängig von dem Spannungsverhältnis und somit abhängig von einer Kopplung und abhängig von dem Abstand des Targets ist.

Bei der unabhängigen Lösung, bei der eine konstante Sendespannung verwendet wird, ist die Auswerteeinrichtung nur mit der Empfangsspule verbunden.

Erfindungsgemäß wurde erkannt, dass sich ein Spannungsverhältnis zwischen dem in der Empfangsspule induzierten Empfangsspannung und der in der Anregungseinrichtung und/oder der Sendespule auftretenden Sendespannung sich proportional zum Abstand eines Targets ändert, wenn die Sendespannung eine hochfrequente Spannung ist. Ein solches Spannungsverhältnis kann von der Auswerteeinrichtung des Näherungssensors erfasst werden, der somit eine genaue Abstandsinformation liefert. Gleiches gilt für die gemessene Empfangsspannung bei konstanter Sendespannung.

Es wurde erfindungsgemäß festgestellt, dass sich Koppelfaktoren zwischen der Sendespule und des metallischen Targets mit unterschiedlichen Materialien bei hohen Frequenzen angleichen. Das gemessene Spannungsverhältnis gibt dann ein dem Abstand proportionalen Wert an, der nahezu unabhängig vom metallischen Material des Targets ist. Besonders der Unterschied zwischen ferromagnetischen und nicht ferromagnetischen Materialen wirkt sich nicht auf das Spannungsverhältnis und damit nicht auf den dadurch ermittelten Abstand aus.

Das Spannungsverhältnis oder die Empfangsspannung kann digital oder analog ausgewertet werden. Bei einer analogen Spannungsverhältnisbildung kann das Signal anschließend digitalisiert werden zur weiteren Auswertung.

Erfindungsgemäß weist die sinusförmige hochfrequente Sendespannung eine Frequenz von 0,5 MHz bis 5 MHz auf, insbesondere 1 MHz bis 3 MHz. Bei dem Frequenzbereich von 0,5 MHz bis 5 MHz gleichen sich die Koppelfaktoren zwischen Sendespule und des metallischen Targets mit unterschiedlichen Materialen an und gleichzeitig ist in diesem Frequenzbereich eine maximale Empfangsspannungsänderung vorhanden, die zu einer maximalen Empfindlichkeit führt. In dem bevorzugten Bereich von 1 MHz bis 3 MHz ist die Anregungseinrichtung und die Auswerteeinrichtung besonders einfach und kostengünstig aufgebaut.

In Weiterbildung der Erfindung ist die Auswerteeinrichtung durch einen Analog/Digital-Wandler gebildet, wobei die Empfangsspannung auf einen Analog/Digital-Wandler Eingang geführt ist und die Sendespannung als Referenzspannung an den Analog/Digital-Wandler angeschlossen ist. Durch die Verwendung eines Analog/Digitalwandlers ist die Auswerteeinrichtung besonders einfach ausgeführt, da die Sendespannung direkt als Referenzspannung an einem Referenzspannungseingang des Analog/Digital-Wandlers angeschlossen ist.

Gemäß einer weiteren Ausführungsform ist die Auswerteeinrichtung durch einen Analog/Digital-Wandler und eine Divisionseinheit gebildet, wobei mit dem Analog/Digital-Wandler sowohl die Sendespannung als auch die Empfangsspannung digitalisierbar ist, und die Divisionseinheit vorgesehen ist zur Division der digitalen Werte der Sendespannung und Empfangsspannung. Dadurch dass der Analog/Digital-Wandler nacheinander, also abwechselnd die Empfangsspannung und Sendespannung digitalisiert, ist nur ein einziger Analog/Digital-Wander notwendig. Wandlungsfehler des Analog/Digital-Wandlers wirken sich dabei in gleichem Maße auf die digitalen Werte der Sende- sowie der Empfangsspannung auf. Die digitalen Werte der Sende- oder Empfangsspannung werden in einem Speicher zwischengespeichert, damit beide Werte für die Divisionseinheit zur Verfügung stehen.

Gemäß einer bevorzugten Ausführungsform ist die Auswerteeinrichtung alternativ durch zwei Analog/Digital-Wandler und eine Divisionseinheit gebildet, wobei mit einem ersten Analog/Digital-Wandler die Sendespannung digitalisierbar ist, mit einem zweiten Analog/Digitalwandler die Empfangsspannung digitalisierbar ist und die Divisionseinheit vorgesehen ist zur Division der digitalen Werte des ersten Analog/Digital-Wandlers und des zweiten Analog/Digitalwandlers. Durch die digitale Divisionseinheit ist die Bildung des Spannungsverhältnisses von Sendespannung und Empfangsspannung einfach. Die digitalen Werte sind einfach zu verarbeiten und das Spannungsverhältnis kann vorteilhaft als digitale Größe als Ausgabesignal ausgegeben werden. Beispielsweise können die digitalen Werte durch eine Schnittstelle wie I/O-Link ausgegeben werden, bei der Schaltsignale und Nachrichten auf einer gemeinsamen Leitung ausgegeben werden können.

Gemäß der Erfindung ist die Anregungseinrichtung durch die Sendespule mit einem Kondensator zu einem LC-Oszillator ausgebildet, welcher die Sendespannung erzeugt. Durch die Verwendung des LC-Oszillators als Sendeschwingkreis kann auf sehr einfache Art und Weise die Sendespannung erzeugt werden und gleichzeitig Energie gespart werden, da ein Großteil der Energie im Sendeschwingkreis gespeichert wird.

In Weiterbildung der Erfindung ist ein Spannungsregler vorhanden, der die Sendespannung auf einen konstanten Wert regelt. Dadurch ist die Empfangsspannung nur noch von den Koppelfaktoren und den Induktivitäten der Sendespule und der Empfangsspule abhängig und wird von keinem zusätzlichen Referenzelement beeinflusst.

In einer bevorzugten Ausführungsform ist die Auswerteeinheit durch einen $\Sigma\Delta$-Modulator gebildet. Die Empfangsspannung der Empfangsinduktivität wird dem Eingang des einen $\Sigma\Delta$-Modulators zugeführt und von diesem durch ein Filter, im Folgenden Schleifenfilter genannt, an einen A/D-Wandler geführt, an dessen Ausgang ein Signal anliegt, das Auskunft über den Abstand des Targets gibt. Durch die Verwendung eines $\Sigma\Delta$-Modulators kann eine sehr empfindliche Auswertung und hohe Auflösung der Empfangsspannung vorgenommen werden. So ist es beispielsweise möglich, Spannungsänderungen im Bereich von $10^{-6}$ der Empfangsspannung

zu erfassen und auszuwerten. Die hohe Auflösung wird aufgrund der Noise-Shaping Eigenschaft des $\Sigma\Delta$-Modulators begünstigt, durch welche Störeinflüsse (z. B. weißes Rauschen) weitgehend unterdrückt werden können.

In der Zeichnung zeigt:

Figur 1    einen ersten erfindungsgemäßen induktiven Sensor;

Figur 2    einen zweiten erfindungsgemäßen induktiven Sensor;

Figur 3    ein Ersatzschaltbild einer Sendespule und eines metallischen Targets;

Figur 4    ein Ersatzschaltbild mit Sendespule, Empfangsspule und einem metallischen Target;

Figur 5;    ein Ersatzschaltbild gemäß Figur 2, wobei die Sendespule in einem LC-Oszillator integriert ist.

In den nachfolgenden Figuren sind gleiche Teile mit gleichen Bezugszeichen gekennzeichnet.

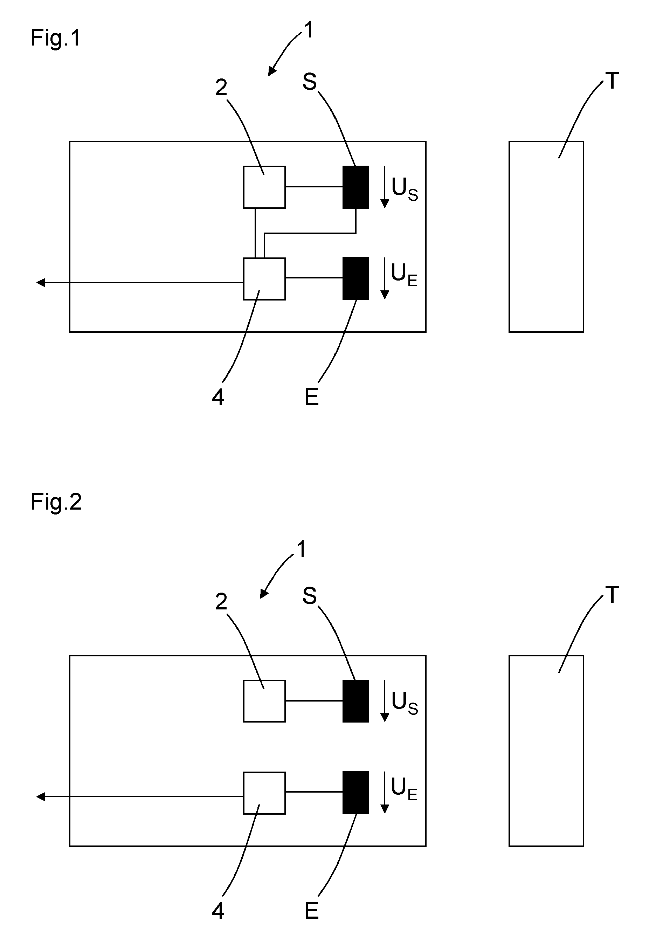

Figur 1 zeigt einen ersten erfindungsgemäßen induktiven Näherungssensor 1 mit einer Sendespule S, einer Empfangsspule E, einer Anregungseinrichtung 2, die mit der Sendespule S verbunden ist und einer Auswerteeinrichtung 4, die mit der Sendespule S und/oder der Anregungseinrichtung 2 sowie mit der Empfangsspule E verbunden ist. Die Auswerteeinrichtung 4 ist ausgebildet ein Ausgabesignal zu erzeugen, das von einem Spannungsverhältnis zwischen einer Sendespannung $U_S$ der Sendespule S und/oder der Anregungseinrichtung 2 sowie einer Empfangsspannung $U_E$ der Empfangsspule E abhängt. Die Anregungseinrichtung 2 ist ausgebildet eine sinusförmige hochfrequente Sendespannung $U_S$ zu erzeugen. Die Empfangsspannung $U_E$ wird dabei von einem metallischen Target T beeinflusst, das von dem induktiven Näherungssensor 1 detektiert werden soll.

Figur 2 zeigt einen zweiten erfindungsgemäßen induktiven Näherungssensor 1 mit einer Sendespule S, einer Empfangsspule E, einer Anregungseinrichtung 2, die mit der Sendespule S verbunden ist und einer Auswerteeinrichtung 4, die mit der Empfangsspule E verbunden ist. Die Auswerteeinrichtung 4 ist ausgebildet ein Ausgabesignal zu erzeugen, das von einer Empfangsspannung $U_E$ der Empfangsspule E abhängig ist. Die Anregungseinrichtung 2 ist ausgebildet eine sinusförmige hochfrequente konstante Sendespannung $U_S$ zu erzeugen. Wie zu Figur 1 bereits erläutert, wird die Empfangsspannung $U_E$ von einem metallischen Target T beeinflusst, das von dem induktiven Näherungssensor 1 detektiert werden soll.

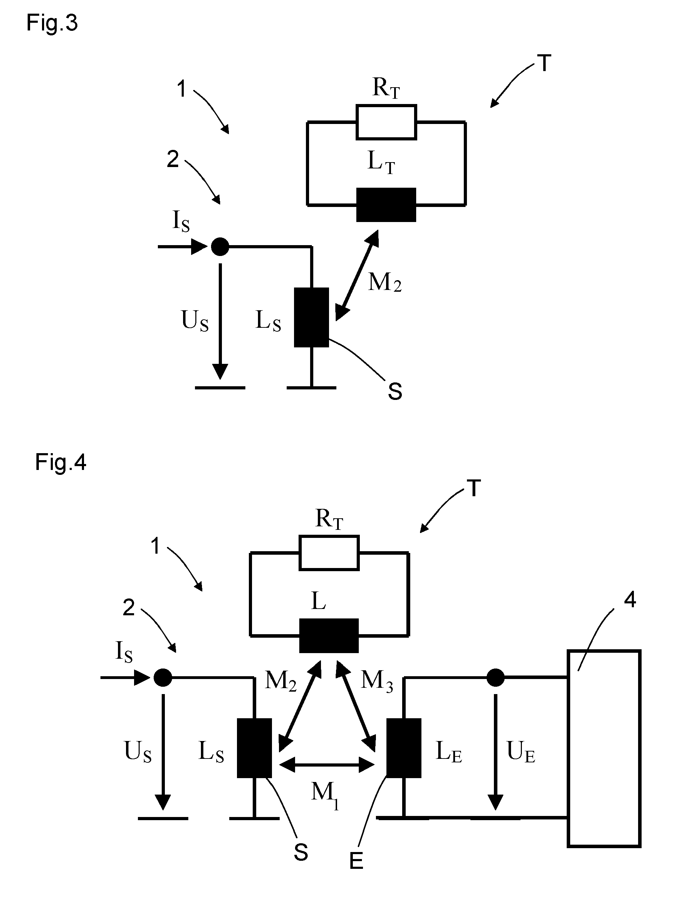

In Figur 3 ist das Ersatzschaltbild einer Sendespule S und eines metallischen Targets T aus Figur 1 und 2 dargestellt. Die nachfolgende Berechnung zeigt gemäß der Erfindung, wie mit Hilfe einer Hochfrequenz im Megahertz-Bereich (MHz) und einem materialunabhängigen Koppelfaktor ein materialunabhängiges Abstandssignal von dem induktiven Näherungssensor erzeugt wird.

Das Ersatzschaltbild gemäß Figur 3 wird durch folgendes Differentialgleichungssystem beschrieben, wobei $U_S$ die Sendespannung, $L_S$ die Induktivität der Sendespule S, $M_2$ die Gegeninduktivität, $L_T$ die Induktivität des Targets T, $R_T$ den Innenwiderstand des Targets, $I_S$ den Sendestrom und $I_T$ den Targetstrom darstellt.

$$U_S = \frac{dI_S}{dt}L_S + \frac{dI_T}{dt}M_2$$

$$0 = I_T R_T + \frac{dI_T}{dt}L_T + \frac{dI_S}{dt}M_2$$

Durch Transformation des Gleichungssystems vom Zeitbereich in den Frequenzbereich durch Laplace-Transformation und Umstellung der Gleichungen nach $U_S/I_S$ erhält man eine Gleichung im Frequenzbereich mit einem Koppelfaktor $K_2$.

Untersuchungen der Erfinder haben gezeigt, dass bei hohen Frequenzen der folgende für die Erfindung wesentliche Zusammenhang gilt, nämlich dass bei hohen Frequenzen im Hochfrequenzbereich, also im MHz-Bereich, die Koppelfaktoren zwischen der Sendespule S sowie dem metallischen Target T mit unterschiedlichen Materialien sich angleichen:

$$\omega^2 >> \left(\frac{R_T}{L_T}\right)^2$$

Unter dieser Bedingung lässt sich die Impedanz der Sendespule S stark vereinfachen:

$$\frac{U_S}{I_S} = K_2{}^2 L_S \frac{R_T}{L_T} + j\omega L_S (1 - K_2{}^2)$$

Das Ergebnis zeigt, dass der Imaginärteil der Spulenimpedanz unabhängig vom Materialparameter $R_T/L_T$ ist und nur noch vom Koppelfaktor $K_2$ abhängt, der nahezu unabhängig vom verwendeten Targetmaterial ist.

Daraus lässt sich ein erstes Messverfahren ableiten. Die Frequenz eines harmonischen LC-Oszillators, der bei einer hohen Frequenz im Hochfrequenzbereich arbeitet, ist eine materialunabhängige Größe für einen Targetabstand. Das belegt die folgende Gleichung für die Resonanzfrequenz eines LC-Oszillators mit einem Kondensator C1 mit einer Kapazität C:

$$f_R = \frac{1}{2\pi}\sqrt{\frac{1}{CL_S(1-K_2^2)}}$$

Dieses Verfahren wird wie im Folgenden dargestellt noch weiter verbessert. Bisher wirken sich die Eigenschaften des Kondensators C1 mit der Kapazität C also dessen Genauigkeit, Alterung und Temperaturdrift direkt auf das Messsignal aus. Weiter benötigt eine hochauflösende Frequenzmessung eine große Messzeit, was die zu verarbeitende Signalbandbreite einschränkt. Aus diesem Grund wird im nächsten Schritt der Absolutwert der Impedanz der Sendespule S berechnet, wobei die Angleichung der Koppelfaktoren $K_2$ bei hohen Frequenzen erneut zu einer starken Vereinfachung der Impedanz der Sendespule S führt:

$$\left|\frac{U_S}{I_S}\right| = \omega L_S(1-K_2^2)$$

Das Ergebnis zeigt, dass der Absolutwert der Impedanz der Sendespule S im Hochfrequenzbereich ebenfalls nahezu unabhängig vom Targetmaterial ist.

Daraus lassen sich zwei verbesserte Messverfahren ableiten, wie in Figur 4 dargestellt. Wird die Sendespule S mit einem hochfrequenten sinusförmigen Strom $I_S$ mit konstanter bzw. targetunabhängiger Amplitude gespeist, erhält man über die Messung der Empfangsspannung $U_E$ ein materialunabhängiges Maß für den Targetabstand. Umgekehrt erhält man bei Speisung mit einer sinusförmigen hochfrequenten Spannung $U_S$ mit konstanter bzw. targetunabhängiger Spannungsamplitude durch Messung des Stromes die gleiche Information.

Beide Messverfahren werden wie im Folgenden dargestellt noch weiter verbessert. Die Erzeugung eines stabilen sinusförmigen Stroms $I_S$ bedarf eines genauen Widerstandes, dessen Eigenschaften, nämlich dessen Genauigkeit, Alterung, Temperaturdrift in das Messergebnis eingehen. Das gleiche gilt umgekehrt bei der Spannungsspeisung für die Strommessung.

Dieses Problem lässt sich mit Hilfe einer Empfangsspule E gemäß Figur 4 lösen, welche die Strominformation bei Speisung mit einer sinusförmigen Spannung $U_S$ wieder in ein Spannungssignal umwandelt. Der große Vorteil dieses Konzeptes besteht darin, dass man durch die Messung der Empfangsspannung $U_E$ und Bildung des Verhältnisses mit der targetunabhängigen, konstanten oder bekannten Sendespannung $U_S$ ein materialunabhängiges Maß für den Targetabstand erhält, das unabhängig von einem genauen Referenzwert wie Widerstandswert, Spannungswert oder Frequenzwert ist.

Das Ersatzschaltbild dieses Ausführungsbeispiels ist in Figur 4 gezeigt. Die folgende Berechnung zeigt die Funktion dieses Ausführungsbeispiels.

Das Ersatzschaltbild gemäß Figur 4 wird durch folgendes Differentialgleichungssystem beschrieben, wobei $U_S$ die Sendespannung, $L_S$ die Induktivität der Sendespule S und $M_2$ die Gegeninduktivität, $L_T$ die Induktivität des Targets, $R_T$ den Innenwiderstand des Targets, $I_S$ den Sendestrom und $I_T$ den Targetstrom, $U_E$ die Empfangsspannung, $M_1$ eine Gegeninduktivität und $M_3$ eine Gegeninduktivität darstellt.

$$U_S = \frac{dI_S}{dt}L_S + \frac{dI_T}{dt}M_2$$

$$0 = I_T R_T + \frac{dI_T}{dt}L_T + \frac{dI_S}{dt}M_2$$

$$U_E = \frac{dI_S}{dt}M_1 + \frac{dI_T}{dt}M_3$$

Durch Transformation des Gleichungssystems in den Frequenzbereich durch Laplace-Transformation und Umstellung der Gleichungen nach $U_E/I_S$, Betragsbildung und anschließender Vereinfachung wonach die Koppelfaktoren sich bei hohen Frequenzen angleichen, erhält man eine Gleichung $|U_E/U_S|$, wobei $K_1$, $K_2$ und $K_3$ jeweils einen Koppelfaktor darstellt:

$$\omega^2 \gg \left(\frac{R_T}{L_T}\right)^2$$

$$\left|\frac{U_E}{U_S}\right| = \sqrt{\frac{L_E}{L_S}}\frac{(K_1 - K_2 K_3)}{1 - K_2^2}$$

Das Ergebnis zeigt, dass man mit diesem Ausführungsbeispiel, bei dem die Sendespule S mit einer hochfrequenten sinusförmigen Spannung $U_S$ gespeist wird, welche eine bekannte oder konstante Spannungsamplitude hat, durch Verhältnisbildung mit der Empfangsspannung $U_E$ an der hochohmig abgegriffenen Empfangsspule E ein Ausgabesignal erhält, welches unabhängig vom Targetmaterial, ein Maß für den Targetabstand darstellt. Dieses Signal ist nur noch von den Koppelfaktoren $K_1$, $K_2$ und $K_3$ und Induktivitäten $L_S$ und $L_E$ abhängig und wird von keinem zusätzlichen Referenzelement beeinflusst.

Natürlich ist es auch möglich, die Sendespule S sendeseitig mit einem hochfrequenten sinusförmigen Strom $I_S$ zu speisen. Dazu wäre aber wiederum ein Referenzwiderstand nötig.

Im Folgenden wird als weiteres Ausführungsbeispiel, die Speisung der Sendespule S mit einer hochfrequenten sinusförmigen Sendespannung $U_S$, deren Amplitude bekannt bzw. konstant ist, weiter verbessert, so dass diese sinusförmige Sendespannung $U_S$ relativ einfach zu implementieren ist und zusätzlich der Energieverbrauch relativ klein ist, da der Speisestrom gespeichert wird.

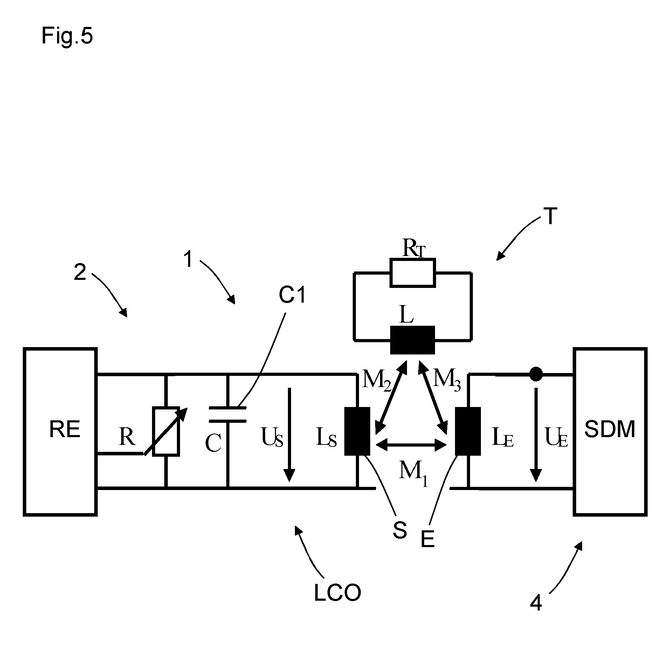

Zur weiteren Verbesserung wird die Sendespule in einen LC-Oszillator LCO eingebunden gemäß Figur 5. Dadurch wird eine sinusförmige Spannung $U_S$ erzeugt und die eingespeiste Energie zum Teil im Schwingkreis gespeichert.

Ein Nachteil eines Schwingkreises, der mit einem konstanten Strom gespeist wird, besteht darin, dass die Spannungsamplitude hauptsächlich vom Realteil der Spulenimpedanz abhängig ist. Das bedeutet, dass die Sendeamplitude nicht mehr unabhängig vom Targetmaterial ist.

Der Schwingkreis wird weiter dadurch verbessert, dass eine Sendespule S verwendet wird, bei dem die Sendespule S in einen LC-Oszillator LCO eingebunden wird, dessen Schwingungsamplitude mit einem Regler RE und beispielsweise einem veränderbaren Widerstand R auf einen konstanten Wert geregelt wird. Dadurch ist die oben berechnete Formel gültig und man erhält durch hochohmige Messung der Spannungsamplitude der Empfangsspannung $U_E$ wiederum ein materialunabhängiges Ausgabesignal für den Targetabstand. In Figur 5 ist das Ersatzschaltbild dieses Ausführungsbeispiels dargestellt.

Eine weitere Möglichkeit besteht darin, sowohl die Spannungsamplitude der Empfangsspannung $U_E$ als auch die Spannungsamplitude der Sendespannung $U_S$ zu messen und das Verhältnis dieser beiden Werte zu bilden. Das kann zum Beispiel dadurch geschehen, dass beide Werte mit einem einzigen Analog/DigitalWandler oder getrennten Analog/Digital-Wandlern digitalisiert und anschließend dividiert werden. Eine weitere Möglichkeit besteht darin, die Sendespannung $U_S$ als Referenzspannung an einem ADC zu verwenden, der die Empfangsamplitude digitalisiert, was ebenfalls einer Division entspricht.

Eine weitere Möglichkeit besteht darin, einen Sigma-Delta-Modulator ($\Sigma\Delta$-Modulator) SDM als Auswerteeinrichtung 2 zu verwenden. Die Empfangsspannung $U_E$ der Empfangsinduktivität $L_E$ wird dem Eingang des $\Sigma\Delta$-Modulators SDM zugeführt und von diesem durch ein Filter, im Folgenden Schleifenfilter genannt, an einen A/D-Wandler geführt, an dessen Ausgang ein Signal anliegt, das Auskunft über den Abstand des Targets gibt, das zu einem geeigneten Ausgabesignal führt. Eine hohe Genauigkeit wird durch die an sich bekannte Rauschformung des $\Sigma\Delta$-Modulators SDM möglich, durch welche ein Quantisierungsrauschen zu höheren Frequenzen hin verschoben wird, wodurch das Nutzsignal, also die Empfangsspannung $U_E$ mit einem hohen Signal-Rauschabstand erfasst werden kann.

Bezugszeichen:

| 1 | Induktiver Näherungssensor |
|---|---|
| 2 | Anregungseinrichtung |
| 4 | Auswerteeinrichtung |
| $U_S$ | Sendespannung |
| $U_E$ | Empfangsspannung |
| | |
| S | Sendespule |
| E | Empfangsspule |
| C1 | Kondensator |
| $L_S$ | Induktivität der Sendespule S |
| $L_E$ | Induktivität der Empfangsspule E |
| $L_T$ | Induktivität eines Targets |
| | |
| T | Target |
| C | elektrische Kapazität eines Kondensators C1 |
| | |
| $I_S$ | Sendestrom |
| $I_T$ | Targetstrom |
| | |
| $M_1$ | Gegeninduktivität |
| $M_2$ | Gegeninduktivität |
| $M_3$ | Gegeninduktivität |
| | |
| $K_1$ | Koppelfaktor |
| $K_2$ | Koppelfaktor |
| $K_3$ | Koppelfaktor |
| | |
| $R_T$ | Innenwiderstand eines Targets |
| R | veränderbarer elektrischer Widerstand |
| RE | Regler |
| SDM | Sigma-Delta-Modulator ($\Sigma\Delta$-Modulator) |
| LCO | LC-Oszillator |

**Patentansprüche**

1. Induktiver Näherungssensor, mit einer Sendespule (S), einer Empfangsspule (E),
einer Anregungseinrichtung (2), die mit der Sendespule (S) verbunden ist und einer Auswerteeinrichtung (4), die mit der Sendespule (S) und der Anregungseinrichtung (2) sowie mit der Empfangsspule (E) verbunden ist
wobei
die Auswerteeinrichtung (4) ausgebildet ist, ein Ausgabesignal zu erzeugen, das von einem Spannungsverhältnis zwischen einer Sendespannung ($U_S$) der Sendespule (S) und/oder der Anregungseinrichtung (2) sowie einer Empfangsspannung ($U_E$) der Empfangsspule (E) abhängig ist, wobei die Anregungseinrichtung (2) ausgebildet ist, eine sinusförmige hochfrequente Sendespannung ($U_S$) zu erzeugen, **dadurch gekennzeichnet, dass** die sinusförmige hochfrequente

Sendespannung (U$_S$) eine Frequenz von 0,5 MHz bis 5 MHz aufweist, wobei die Anregungseinrichtung (2) durch die Sendespule (S) mit einem Kondensator (C) einen LC-Oszillator (LCO) bildet, welcher ausgebildet ist, die Sendespannung (U$_S$) zu erzeugen.

2. Induktiver Näherungssensor, mit einer Sendespule (S), einer Empfangsspule (E), einer Anregungseinrichtung (2), die mit der Sendespule (S) verbunden ist und einer Auswerteeinrichtung (4), die nur mit der Empfangsspule (E) verbunden ist
wobei
die Auswerteeinrichtung (4) ausgebildet ist, ein Ausgabesignal zu erzeugen, das von einer Empfangsspannung (U$_E$) der Empfangsspule (E) abhängig ist, wobei die Anregungseinrichtung (2) ausgebildet ist, eine sinusförmige hochfrequente Sendespannung (U$_S$) mit konstanter Amplitude zu erzeugen, **dadurch gekennzeichnet, dass**
die sinusförmige hochfrequente Sendespannung (U$_S$) eine Frequenz von 0,5 MHz bis 5 MHz aufweist, wobei die Anregungseinrichtung (2) durch die Sendespule (S) mit einem Kondensator (C) einen LC-Oszillator (LCO) bildet, welcher ausgebildet ist, die Sendespannung (U$_S$) zu erzeugen.

3. Induktiver Näherungssensor nach Anspruch 1 oder 2,
wobei
die sinusförmige hochfrequente Sendespannung (U$_S$) eine Frequenz von 1 MHz bis 3 MHz aufweist.

4. Induktiver Näherungssensor nach einem der vorhergehenden Ansprüche, wobei
die Auswerteeinrichtung (4) durch einen Analog/Digital-Wandler gebildet ist, wobei die Empfangsspannung (U$_E$) auf den Analog/Digital-Wandler Eingang geführt ist und die Sendespannung (U$_S$) als Referenzspannung an den Analog/Digital-Wandler angeschlossen ist.

5. Induktiver Näherungssensor nach einem der vorhergehenden Ansprüche 1 bis 3, wobei
die Auswerteeinrichtung (4) durch einen Analog/Digital-Wandler und eine Divisionseinheit gebildet ist, wobei mit dem Analog/Digital-Wandler sowohl die Sendespannung (U$_S$) als auch die Empfangsspannung digitalisierbar ist, und die Divisionseinheit vorgesehen ist zur Division der digitalen Werte der Sendespannung (U$_S$) und Empfangsspannung (U$_E$) oder die Auswerteeinrichtung (4) durch zwei Analog/Digital-Wandler und eine Divisionseinheit gebildet ist, wobei mit einem ersten Analog/Digital-Wandler die Sendespannung (U$_S$) digitalisierbar ist, mit einem zweiten Analog/Digitalwandler die Empfangsspannung (U$_E$) digitalisierbar ist und die Divisionseinheit vorgesehen ist zur Division der digitalen Werte des ersten Analog/Digital-Wandlers und des zweiten Analog/Digitalwandlers.

6. Induktiver Näherungssensor nach einem der vorhergehenden Ansprüche, wobei
ein Regler (RE), insbesondere Spannungsregler vorhanden ist, der die Sendespannung (U$_S$) auf einen konstanten Wert regelt.

7. Induktiver Näherungssensor nach einem der vorhergehenden Ansprüche, wobei
die Auswerteeinheit durch einen $\Sigma\Delta$-Modulator (SDM) gebildet ist.

8. Verfahren zur Detektion von metallischen Targets, mit einer Sendespule (S) zur Erzeugung eines Magnetfeldes, einer Empfangsspule (E), welche durch das Magnetfeld beeinflusst wird,
einer Anregungseinrichtung (2), welche die Sendespule (S) anregt und einer Auswerteeinrichtung (4), welche die Sendespule (S) und die Anregungseinrichtung (2) sowie die Empfangsspule (E) auswertet,
wobei
die Auswerteeinrichtung (4) ein Ausgabesignal erzeugt, das von einem Spannungsverhältnis zwischen einer Sendespannung (U$_S$) der Sendespule (S) und/oder der Anregungseinrichtung (2) sowie einer Empfangsspannung (U$_E$) der Empfangsspule (E) abhängt, wobei die Anregungseinrichtung (2) eine sinusförmige hochfrequente Sendespannung (U$_S$) erzeugt, **dadurch gekennzeichnet, dass** die sinusförmige hochfrequente Sendespannung (U$_S$) eine Frequenz von 0,5 MHz bis 5 MHz aufweist, wobei die Anregungseinrichtung (2) die Sendespannung (U$_S$) durch Oszillation erzeugt.

9. Verfahren zur Detektion von metallischen Targets, mit einer Sendespule (S) zur Erzeugung eines Magnetfeldes, einer Empfangsspule (E), welche durch das Magnetfeld beeinflusst wird,
einer Anregungseinrichtung (2), welche die Sendespule (S) anregt und einer Auswerteeinrichtung (4), welche nur die Empfangsspule (E) auswertet,
wobei
die Auswerteeinrichtung (4) ein Ausgabesignal erzeugt, das von einer Empfangsspannung (U$_E$) der Empfangsspule (E) abhängt, wobei die Anregungseinrichtung (2) eine sinusförmige hochfrequente konstante Sendespannung (U$_S$) mit konstanter Amplitude erzeugt, **dadurch gekennzeichnet, dass** die sinusförmige hochfrequente Sendespannung (U$_S$) eine Frequenz von 0,5 MHz bis 5 MHz aufweist, wobei die Anregungseinrichtung (2) die Sendespannung (U$_S$) durch Oszillation erzeugt.

10. Verfahren zur Detektion von metallischen Targets nach Anspruch 8 oder 9, wobei

die sinusförmige hochfrequente Sendespannung ($U_S$) eine Frequenz von 1 MHz bis 3 MHz aufweist.

11. Verfahren zur Detektion von metallischen Targets nach einem der vorhergehenden Ansprüche 8 bis 10, wobei
die Auswerteeinrichtung (4) eine Analog/Digital-Wandlung durchführt, wobei die Empfangsspannung ($U_E$) als Eingangsgröße und die Sendespannung ($U_S$) als Referenzgröße für die Analog/Digital-Wandlung dient.

12. Verfahren zur Detektion von metallischen Targets nach einem der vorhergehenden Ansprüche 8 bis 10 wobei
die Auswerteeinrichtung (4) eine Analog/Digital-Wandlung und eine Division durchführt, wobei bei jeweils einer zeitlich getrennten Analog/Digital-Wandlung die Sendespannung ($U_S$) und die Empfangsspannung digitalisiert wird, und die digitalen Werte der Sendespannung ($U_S$) und Empfangsspannung ($U_E$) dividiert werden oder die Auswerteeinrichtung (4) parallel zwei Analog/Digital-Wandlungen und anschließend einer Division durchführt, wobei bei einer ersten Analog/Digital-Wandlung die Sendespannung ($U_S$) digitalisiert wird, bei einer zweiten Analog/Digitalwandlung die Empfangsspannung ($U_E$) digitalisiert wird und die digitalen Werte der Sendespannung ($U_S$) und Empfangsspannung ($U_E$) dividiert werden.

13. Verfahren zur Detektion von metallischen Targets nach einem der vorhergehenden Ansprüche 8 bis 12, wobei
die Sendespannung ($U_S$) auf einen konstanten Wert geregelt wird.

**Claims**

1. Inductive proximity sensor, with a transmitting coil (S), a receiving coil (E), an excitation device (2), which is connected to the transmitting coil (S) and an evaluation device (4) connected to the transmitting coil (S) and the excitation device (2) and connected to the receiving coil (E) in which the evaluation device (4) is designed to generate an output signal dependent from a voltage ratio between a transmission voltage ($U_S$) of the transmitting coil (S) and/or the excitation means (2) and a reception voltage ($U_E$) of the receiving coil (E), wherein the excitation means (2) is formed to produce a sinusoidal high-frequency transmission voltage ($U_S$), **characterized in that** the sinusoidal high frequency transmission voltage ($U_S$) has a frequency of 0.5 MHz to 5 MHz, wherein the excitation means (2) forms an LC oscillator (LCO) through the transmitting coil (S) and a capacitor (C), which is designed to generate the transmitter voltage ($U_S$).

2. Inductive proximity sensor, with a transmitting coil (S), a receiving coil (E), an excitation device (2), which is connected to the transmitting coil (S) and an evaluation device (4) which is only connected to the receiving coil (E) in which the evaluation device (4) is designed to generate an output signal which is dependent from a reception voltage ($U_E$) of the receiving coil (E) wherein the excitation means (2) is designed to generate a sinusoidal high-frequency transmission voltage ($U_S$) with a constant amplitude, **characterized in that** the sinusoidal high frequency transmission voltage ($U_S$) has a frequency of 0.5 MHz to 5 MHz, wherein the excitation means (2) forms an LC oscillator (LCO) through the transmitting coil (S) and a capacitor (C) which is configured to generate the transmit voltage ($U_S$).

3. Inductive proximity sensor according to claim 1 or 2, wherein the sinusoidal high frequency transmission voltage ($U_S$) has a frequency of 1 MHz to 3 MHz.

4. Inductive proximity sensor according to one of the preceding claims, wherein the evaluation device (4) is formed by an analog/digital converter wherein the reception voltage ($U_E$) is fed to the analog/digital converter input and the transmission voltage ($U_S$) is connected to the analog/digital converter as a reference voltage.

5. Inductive proximity sensor according to one of the preceding claims 1 to 3,
wherein the evaluation device (4) is formed by an analog/digital converter and a division unit, wherein both the transmitting voltage ($U_S$) and the receiving voltage are digitalised by the analog/digital converter, and the division unit is provided for dividing the digital values of the transmission voltage ($U_S$) and reception voltage ($U_E$), or the evaluation devoice (4) is formed by two analog/digital converters and a division unit, wherein the transmission voltage ($U_S$) is digitalised by a first analog/digital and with a second analog/digital converter the reception voltage ($U_E$) is digitalised, and the division unit is provided for dividing the digital values of the first analog/digital converter and the second analog/digital converter.

6. Inductive proximity sensor according to one of the preceding claims, wherein a controller (RE), in particular a voltage regulator, is provided which regulates the transmission voltage ($U_S$) to a constant value.

7. Inductive proximity sensor according to one of the preceding claims, wherein the evaluation unit is formed by a $\Sigma\Delta$-modulator (SDM).

8. A method for the detection of metallic targets with a transmitting coil (S) for generating a magnetic field, a receiving coil (E) which is influenced by the magnetic field, an excitation device (2) which excites the transmitting coil (S) and an evaluation device (4) which evaluates the transmitting coil (S) and the excitation device (2) and the receiving coil (E), in which the evaluation device (4) generates an output signal which is dependent from a voltage ratio between a transmission voltage ($U_S$) of the transmitting coil (S) and/or of the excitation means (2) and a reception voltage ($U_E$) of the receiving coil (E), wherein the excitation means (2) produces a sinusoidal high-frequency transmission voltage ($U_S$), **characterized in that** the sinusoidal high frequency transmission voltage ($U_S$) has a frequency of 0.5 MHz to 5 MHz, wherein the excitation means (2) generates the transmission voltage ($U_S$) by oscillation.

9. A method for the detection of metallic targets, with a transmitting coil (S) for generating a magnetic field, a receiving coil (E) which is influenced by the magnetic field, an excitation device (2) which excites the transmitting coil (S) and an evaluation device (4) which evaluates only the receiving coil (E), in which the evaluation device (4) generates an output signal ($U_E$) which is dependent on a reception voltage of the receiving coil (E), wherein the excitation means (2) produces a sinusoidal high-frequency constant transmission voltage ($U_S$) with a constant amplitude, **characterized in that** the sinusodial transmitting high-frequency voltage ($U_S$) has a frequency of 0.5 MHz to 5 MHz, wherein the excitation means (2) generates the transmission voltage ($U_S$) by oscillation.

10. A method for the detection of metallic targets of claim 8 or 9, wherein the high frequency sinusoidal transmitter voltage ($U_S$) has a frequency of 1 MHz to 3 MHz.

11. A method for the detection of metallic targets according to any preceding claims 8 to 10, wherein the evaluation device (4) performs an analog/digital conversion, wherein the reception voltage ($U_E$) as an input variable and the transmission voltage ($U_S$) is used as reference for the analog/digital conversion.

12. A method for the detection of metallic targets according to any preceding claims 8 to 10 wherein the evaluation device (4) performs an analog/digital conversion and a division, wherein in each case of a temporally separated analog/digital conversion the transmission voltage ($U_S$) and the receiving voltage are digitized and the digital values of the transmit voltage ($U_S$) and the reception voltage ($U_E$) are divided or the evaluation device (4) performs parallelly two analog/digital conversions and then a division, wherein for a first analog/digital conversion the transmission voltage ($U_S$) is digitized and for a second analog/digital conversion the reception voltage is digitized ($U_E$) and the digital values of the transmit voltage ($U_S$) and reception voltage ($U_E$) are divided.

13. A method for the detection of metallic targets according to one of the preceding claims 8 to 12, wherein the transmission voltage ($U_S$) is controlled to a constant value.

**Revendications**

1. Capteur de proximité inductif, avec une bobine d'émission (S), une bobine de réception (E), un dispositif d'excitation (2), qui est relié à la bobine émettrice (S) et un dispositif d'évaluation (4) relié à la bobine d'émission (S) et le dispositif d'excitation (2) est relié à la bobine de réception (E), dans lequel le dispositif d'évaluation (4) est conçu pour générer un signal de sortie dépendant d'un rapport de tension entre une tension de transmission (US) de la bobine émettrice (S) et / ou les moyens d'excitation (2) et une tension de réception (UE) de la bobine de réception (E), dans lequel les moyens d'excitation (2) sont formés pour produire une tension de transmission à haute fréquence sinusoïdale (US), **caractérisé en ce que** la tension à haute fréquence de transmission sinusoïdale (US) ait une fréquence de 0,5 MHz à 5 MHz, dans lequel les moyens d'excitation (2) forment un oscillateur LC (LCO) à travers la bobine émettrice (S) et un condensateur (C), qui est conçu pour générer la tension d'émetteur (US).

2. Détecteur inductif de proximité, avec une bobine d'émission (S), une bobine de réception (E), un dispositif d'excitation (2), qui est relié à la bobine émettrice (S) et un dispositif d'évaluation (4) qui est relié uniquement à la bobine de réception (E), dans lequel le dispositif d'évaluation (4) est conçu pour générer un signal de sortie qui dépend d'une tension de réception (UE) de la bobine de réception (E), dans laquelle les moyens d'excitation (2) sont conçus pour générer un sinusoïdal à haute fréquence la tension de transmission (US) avec une amplitude constante, **caractérisé en ce que** la tension à haute fréquence de transmission sinusoïdale (US) ait une fréquence de 0,5 MHz à 5 MHz, dans laquelle les moyens d'excitation (2) forment un oscillateur LC (LCO) à travers la bobine émettrice (S) et un condensateur (C) qui est configuré pour générer la tension d'émission (US).

3. Capteur de proximité inductif selon la revendication 1 ou 2, dans laquelle la tension de transmission à haute fréquence sinusoïdale (US) a une fréquence de 1 MHz à 3 MHz.

**4.** Capteur de proximité inductif selon l'une quelconque des revendications précédentes, dans laquelle le dispositif d'évaluation (4) est formée par un convertisseur analogue / digital dans lequel la tension de réception (UE) est envoyée au convertisseur analogue / entrée du convertisseur digital et la tension de transmission (US) est reliée au convertisseur analogue / digital en tant que tension de référence.

**5.** Capteur de proximité inductif selon l'une quelconque des revendications précédentes 1 à 3, dans laquelle le dispositif d'évaluation (4) est formé par un convertisseur analogue / digital et une unité de division, dans lequel à la fois la tension d'émission (US) et la tension de réception sont numérisées par le convertisseur analogue / digital, et l'unité de division est prévue pour diviser les valeurs digitals de la tension de transmission (US) et la tension de réception (UE), ou le dispositif d'évaluation (4) est formé par deux convertisseurs analogues / digitals et une unité de division, dans laquelle la tension de transmission (US) est numérisée par un premier convertisseur analogue / digital et d'un second convertisseur analogue / digital la tension de réception (UE) est numérisée, et l'unité de division est prévue pour diviser les valeurs digitals du premier convertisseur analogue / digital et le deuxième convertisseur analogue / digital.

**6.** Capteur de proximité inductif selon l'une quelconque des revendications précédentes, dans laquelle un dispositif de commande (RE), en particulier un régulateur de tension, est prévu, qui régle la tension de transmission (US) à une valeur constante.

**7.** Capteur de proximité inductif selon l'une quelconque des revendications précédentes, dans laquelle l'unité d'évaluation est formée par un $\Sigma\Delta$-modulateur (SDM).

**8.** Procédé pour la détection de cibles métalliques avec une bobine émettrice (S) pour générer un champ magnétique, une bobine de réception (E) qui est influencée par le champ magnétique, un dispositif d'excitation (2) qui excite la bobine émettrice (S) et un dispositif d'évaluation (4) qui évalue la bobine émettrice (S) et le dispositif d'excitation (2) et la bobine de réception (E), dans laquelle le dispositif d'évaluation (4) génère un signal de sortie qui dépend d'un rapport de tension entre une tension de transmission (US) de la bobine émettrice (S) et / ou des moyens d'excitation (2) et une tension de réception (UE) de la bobine de réception (E), dans laquelle les moyens d'excitation (2) produisent une haute sinusoïdal tension de transmission de fréquence (US), **caractérisé en ce que** la tension de transmission à haute fréquence sinusoïdale (US) ait une fréquence de 0,5 MHz à 5 MHz, dans laquelle les moyens d'excitation (2) génèrent la tension de transmission (US) par oscillation.

**9.** Procédé pour la détection de cibles métalliques, avec une bobine émettrice (S) pour générer un champ magnétique, une bobine de réception (E) qui est influencée par le champ magnétique, un dispositif d'excitation (2) qui excite la bobine d'émission ( S) et un dispositif d'évaluation (4) qui évalue uniquement la bobine de réception (E), dans laquelle le dispositif d'évaluation (4) génère un signal de sortie (UE), qui dépend d'une tension de réception de la bobine de réception (E), dans laquelle l'excitation des moyens (2) produit une haute fréquence de tension de transmission constante sinusoïdale (US) avec une amplitude constante, **caractérisé en ce que** la transmission sinusoïdale de tension à haute fréquence (US) ait une fréquence de 0,5 MHz à 5 MHz, dans laquelle les moyens d'excitation (2) génèrent la tension de transmission (US) par oscillation.

**10.** Procédé pour la détection de cibles métalliques selon la revendication 8 ou 9, dans laquelle la tension haute fréquence de l'émetteur sinusoïdale (US) a une fréquence de 1 MHz à 3 MHz.

**11.** Procédé pour la détection de cibles métalliques selon l'une quelconque des revendications précédentes 8 à 10, dans laquelle le dispositif d'évaluation (4) effectue une conversion analogue / digitale, dans laquelle la tension de réception (UE) en tant que variable d'entrée et la tension de transmission (US) est utilisée comme référence pour la conversion analogue / digitale.

**12.** Procédé pour la détection de cibles métalliques selon l'une quelconque des revendications précédentes 8 à 10, dans laquelle le dispositif d'évaluation (4) exécute une conversion analogue / digitale et une division, dans laquelle, dans chaque cas une conversion analogue / digitale temporellement séparée de la tension de la transmission (US) et la tension de réception sont numérisées et les valeurs digitals de la tension de transmission (US) et la tension de réception (UE) sont divisés ou le dispositif d'évaluation (4) effectue parallèlement deux conversions analogues / digitales, puis une division, dans laquelle pour une première conversion analogue / digitale la tension de la transmission analogue (US) est numérisée et pour une seconde conversion analogue / digitale la tension de réception est numérisée (UE) et les valeurs digitals de la tension d'émission (US) et la tension de réception (UE) sont divisés.

**13.** Procédé pour la détection de cibles métalliques selon l'une quelconque des revendications précédentes 8 à 12, dans laquelle la tension de transmission (US) est commandée à une valeur constante.

Fig.1

Fig.2

Fig.3

Fig.4

Fig.5

**IN DER BESCHREIBUNG AUFGEFÜHRTE DOKUMENTE**

**In der Beschreibung aufgeführte Patentdokumente**

- EP 0371261 A2
- DE 102004029192 A1
- DE 10244104 A1
- DE 19911958 A1

**In der Beschreibung aufgeführte Nicht-Patentliteratur**

- **DYM et al.** *Dual Ramp Analog to Digital Converter with Divide Function for Graphic Tablet*